# EUROPÄISCHE PATENTSCHRIFT

(11) **EP 3 057 785 B1**
(45) Veröffentlichungstag und Bekanntmachung des Hinweises auf die Patenterteilung: **17.08.2022**
(21) Anmeldenummer: 14824761.2
(22) Anmeldetag: 14.10.2014
(51) Int. Cl.: B30B 5/04, B41C 1/18, G03F 7/18

(54) **VERFAHREN ZUM AUFBRINGEN EINER MASKENFÖRMIGEN BESCHICHTUNG AUF EIN ENDLOSBAND**
METHOD FOR APPLYING A MASK-SHAPED COATING TO AN ENDLESS BELT
PROCÉDÉ D'APPLICATION D'UN REVÊTEMENT EN FORME DE MASQUE SUR UNE BANDE CONTINUE

(30) Priorität: 17.10.2013 AT 506712013
(43) Veröffentlichungstag der Anmeldung: 24.08.2016
(73) Patentinhaber: Berndorf Band GmbH, 2560 Berndorf (AT)
(72) Erfinder: BADER, Dieter, A-2560 Berndorf (AT)
(74) Vertreter: Burger, Hannes
(86) Internationale Anmeldenummer: PCT/AT2014/050245
(87) Internationale Veröffentlichungsnummer: WO 2015/054715

(56) Entgegenhaltungen:
- WO-A1-02/094580
- WO-A1-2010/054963
- JP-A- 2002 096 014
- US-A- 6 155 669
- US-A1- 2004 170 762
- US-A1- 2010 225 686

## Beschreibung

Die Erfindung betrifft ein Verfahren gemäß dem Oberbegriff von Anspruch 1.

Weiters betrifft die Erfindung eine Vorrichtung g gemäß dem Oberbegriff von Anspruch 6. Drucker zum Bedrucken von Blättern sind aus der WO2010054963A1 und der US6155669A bekannt geworden. WO 2010 054963 A1 offenbart ein Verfahren, bzw. eine Vorrichtung, gemäss dem Oberbegriff des Anspruchs 1, bzw. des Anspruchs 6.

Ein Verfahren bzw. eine Vorrichtung der eingangs genannten Art ist aus der EP1395443B1 bzw. der WO 02/094580A1 bekannt geworden. Bei der bekannten Lösung wird mittels eines digitalen Druckverfahrens eine maskenförmige Beschichtung aufgebracht, wobei in nicht beschichteten Bereichen des Bandes in einem weiteren Verfahrensschritt ein Material durch Ätzen oder Auftragen von Material eine Strukturierung der Bandoberfläche erzielt wird. Zum Bedrucken des Bandes läuft dieses während des Druckvorganges unter einem in Bewegungsrichtung des Bandes stationären Druckers durch. Bei dem bekannten Verfahren kann es jedoch dazu kommen, dass das Endlosband, welches üblicherweise zwischen zwei Umlenkrollen umläuft, aufgrund von mechanischen Belastungen gedehnt wird, oder dass es zu Geschwindigkeitsänderungen des Endlosbandes während des Druckvorganges kommt. Dies kann zur Folge haben, dass das der Maske entsprechende Druckbild nicht korrekt auf das Endlosband übertragen wird. Aus der US2004/170762 A1 ist ein Drucker zum Aufbringen eines Polymers auf ein Substrat bekannt geworden. Ein weiteres einschlägiges Verfahren ist aus der US2010/225686A1 bekannt geworden.

Es ist daher eine Aufgabe der Erfindung, die oben genannten Nachteile des Stands der Technik zu überwinden.

Die oben genannte Aufgabe wird mit einem Verfahren gemäß Anspruch 1 und eine Vorrichtung gemäss Anspruch 6 gelöst. Unter einer Maßverkörperung wird hier ein einen Maßstab bzw. ein periodische Unterteilungen aufweisendes oder ein eine (kontinuierlich erfassbare) Referenzgröße definierendes Element verstanden. Weist die Maßverkörperung (periodisch) eingeprägte Unterteilungen auf, lässt sich durch Abtastung der Unterteilungen ein Inkrementalgeber realisieren. Unter einer kontinuierlichen Maßverkörperung wird in dem vorliegenden Zusammenhang eine kontinuierlich erfassbare Markierung, beispielsweise eine optische Markierung, verstanden, die auf das Endlosband aufgebracht wird, anhand der sich eine Lage- und Positionsänderung, insbesondere ein seitliches Verlaufen des Endlosbandes erfassen lässt. Bei der kontinuierlichen Maßverkörperung kann es sich beispielsweise um eine auf einer Oberfläche des Endlosbandes aufgetragene sichtbare Linie handeln. Der Begriff "Oberfläche" ist hierbei so zu verstehen, dass darunter sowohl eine Bandaußenfläche als auch eine Bandinnenfläche sowie eine die Bandaußenfläche und die Bandinnenfläche verbindende Seitenfläche fallen. Die Maßverkörperung kann sich beispielsweise auf der Bandinnenfläche oder auf der Bandaußenfläche oder an einer Seitenkante bzw. Seitenfläche des Endlosbandes befinden.

Unter "Aufbringen" werden in dem vorliegenden Zusammenhang sämtliche Verfahren verstanden, bei welchen ein Materialauftrag auf das Endlosband stattfindet, wie beispielsweise Aufdrucken oder Aufkleben der Maßverkörperung. Hingegen werden unter "Übertragen" sämtliche andere Verfahren verstanden, bei welchen die Maßverkörperung auf andere Weise als durch Materialauftrag realisiert wird, wie beispielsweise durch Prägen des Endlosbandes oder durch Materialabtragen, beispielsweise mittels eines Lasers, durch Magnetisieren des Endlosbandes, durch abschnittsweises Umformen des Endlosbandes, etc.

Die erfindungsgemäße Lösung ermöglicht eine Korrektur der Banddehnung oder von Geschwindigkeitsänderungen des in Bezug auf den Drucker umlaufenden Endlosbandes während des Druckvorganges. Auch ein seitlicher Versatz bzw. ein seitliches Verlaufen des Endlosbandes lässt sich durch die erfindungsgemäße Lösung ausgleichen. Somit kann durch die Erfindung eine korrekte Übertragung des Druckbildes auf das Endlosband unabhängig von den oben genannten Störeinflüssen gewährleistet werden.

Als optischer Sensor kann beispielsweise eine Kamera, insbesondere eine CCD-Kamera, verwendet werden. Alternativ zur Verwendung einer Kamera kann auch nur ein Array photosensitiver Elemente verwendet werden, wobei die Oberfläche des Endlosbandes in diesem Fall mit einer Lichtquelle bestrahlt werden kann. Mittels des Arrays aus photosensitiven Elementen kann die Intensitätsverteilung des reflektierten Lichtes erfasst und so die tatsächliche Position der Maßverkörperung bestimmt und sodann mit der Sollposition verglichen werden.

Als besonders vorteilhaft hinsichtlich der Erkennung eines seitlichen Verlaufens sowie von Dehnungen und Geschwindigkeitsänderungen des Endlosbandes hat es sich herausgestellt, dass in Schritt a) die zumindest eine Maßverkörperung parallel zu einer Seitenkante und/oder auf eine Seitenfläche, die eine Bandinnenfläche mit einer Bandaußenfläche des Endlosbandes verbindet, und in Umfangsrichtung umlaufend auf die Oberfläche des Endlosbandes aufgebracht wird.

Darüber hinaus kann in Schritt a) zumindest eine Referenzmarkierung zur Festlegung zumindest eines Referenzpunktes für die Detektion von Teilstrichen der zumindest einen Maßverkörperung auf und/oder in dem Endlosband angebracht werden. Der Referenzpunkt bzw. die Referenzmarkierung kann u. A. beispielsweise dazu verwendet werden, das Endlosband vor dem Bedrucken in eine definierte Lage zu bringen.

Um sowohl eine seitliches Verlaufen als auch Geschwindigkeitsänderungen oder Dehnungen eines während des Druckens kontinuierlich umlaufenden Endlosbandes für den Druckvorgang besonders gut berücksichtigen zu können, kann es vorgesehen sein, dass in Schritt a) zumindest zwei Maßverkörperungen auf das Endlosband aufgebracht werden, wobei eine erste der Maßverkörperungen Teilstriche mit einer periodischen Teilung aufweist, während eine zweite der Maßverkörperungen als kontinuierliche Maßverkörperung, insbesondere in Form einer Linie, ausgebildet ist, wobei in Schritt b) die Teilstriche der ersten Maßverkörperung mit einem ersten Sensor und die Position der zweiten Maßverkörperung mit einem zweiten Sensor erfasst werden. Selbstverständlich ist es auch möglich, die beiden soeben erwähnten Maßverkörperungen in einer gemeinsamen Maßverkörperung zu realisieren. So könnte beispielsweise eine Maßverkörperung verwendet werden, welche als Linie ausgebildet ist und eine (periodische) Unterteilung in Form von Teilstrichen aufweist. Unter Teilstrichen werden in diesem Dokument Strukturen verstanden, die eine Unterteilung der Maßverkörperung darstellen bzw. ermöglichen. Bei Teilstrichen kann es sich beispielsweise um in einen (hartmagnetischen) Träger durch Magnetisierung eingeschriebene, periodisch wiederkehrende Strukturen handeln, die eine Teilung der Maßverkörperung darstellen. Zum Lesen der Unterteilung bzw. der Teilstriche kann im Fall einer Maßverkörperung aus einem magnetischen Trägermaterial beispielsweise ein Hallelement oder auch ein magnetoresistiver Sensor verwendet werden. Die Teilstriche können aber auch durch optisch erfassbare Strukturen, wie graphisch aufgebrachte Linien, Schlitze etc. realisiert sein, welche durch optische Sensoren erfasst werden können.

Hinsichtlich der Erkennung von Banddehnungen hat es sich als besonders günstig herausgestellt, dass die zumindest eine Maßverkörperung in Schritt a) kraftschlüssig auf das Endlosband aufgebracht wird. Alternativ zu einem Auftragen der Maßverkörperung auf das Endlosband kann diese auch durch andere Verfahren, beispielsweise materialabtragende Verfahren, wie Ätzen oder Gravieren, beispielsweise mittels eines Lasers, oder durch umformende Verfahren, wie beispielweise Prägen, realisiert werden. Auch ist es möglich, die Maßverkörperung durch Änderung von Materialeigenschaften des Endlosbandes, beispielsweise durch Magnetisieren des Endlosbandes, herzustellen.

Die oben genannte Aufgabe lässt sich auch mit einer Vorrichtung gemäß dem Oberbegriff von Anspruch 6 durch die Merkmale des kennzeichnenden Teils von Anspruch 6 lösen.

Die Erfindung ist von Vorteil, um die Bewegungen des Sensors zur Erkennung des Verlaufens des Endlosbandes quer zu dessen Umlaufrichtung und dem Drucker zu synchronisieren. Eine Synchronisation der Bewegungen von Sensor und Drucker hat den Vorteil, dass der Sensor in seiner Lage verändert werden kann, bis die Position der Maßverkörperung auf der Sensorfläche wieder der Sollposition entspricht, wobei der Drucker gleichzeitig ebenfalls um diesen Betrag verschoben und somit um das Verlaufen des Endlosbandes korrigiert positioniert wird.

Gemäß einer vorteilhaften Variante der Erfindung kann der zumindest eine Drucker mittels zumindest eines Aktors in Querrichtung des Endlosbandes verschiebbar sein.

Entsprechend einer vorteilhaften Weiterbildung der Erfindung kann es vorgesehen sein, dass der Aktor mit einer mit dem zumindest einen Sensor verbundenen Steuerung verbunden ist, die dazu eingerichtet ist, den Aktor entsprechend einer Abweichung der Position der Maßverkörperung von einer Sollposition zu verstellen.

Zum besseren Verständnis der Erfindung wird diese anhand der nachfolgenden Figur näher erläutert.

Es zeigt in stark vereinfachter, schematischer Darstellung:

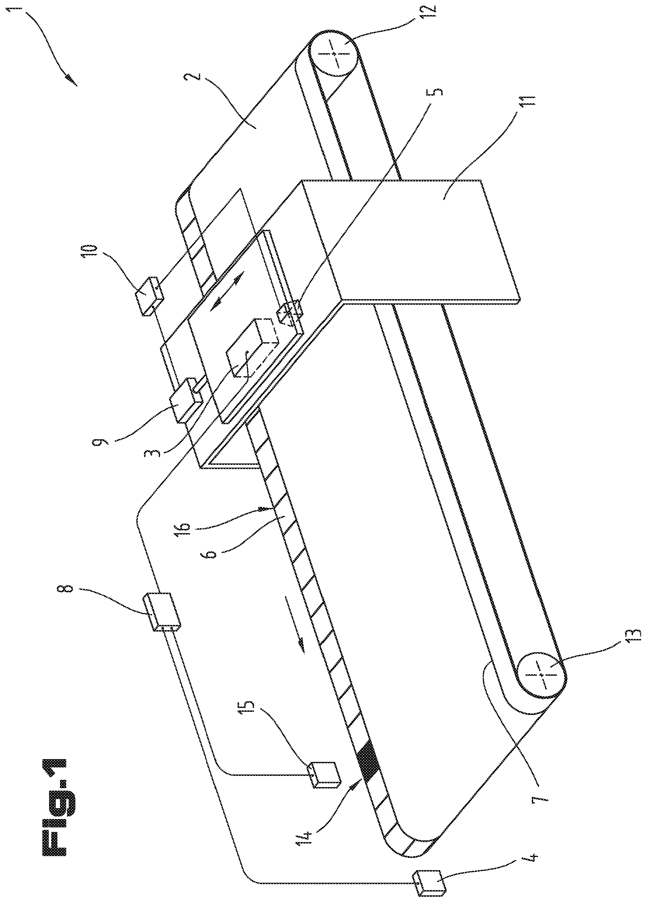

- Fig. 1: eine perspektivische Ansicht einer erfindungsgemäßen Vorrichtung.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Gemäß Fig. 1 weist eine erfindungsgemäße Vorrichtung 1 zum Auftragen einer maskenförmigen Beschichtung auf ein Endlosband 2 einen digitalen Drucker 3 auf. Der Drucker 3 dient zum Ausstoßen eines Beschichtungsmaterials in Tropfenform auf eine Außenfläche des Endlosbandes 2.

Die Vorrichtung 1 weist in der dargestellten Ausführungsform einen Sensor 4 zur Erfassung eines Anfangs oder Endes einer Teilungsperiode einer auf dem Endlosband 1 aufgebrachten Maßverkörperung 6 auf. Die Maßverkörperung 6 weist Teilstriche 16, die eine periodische Teilung definieren, auf.

Der Sensor 4 ist mit einer Steuerung 8 des Druckers 3 verbunden und eingerichtet, ein Signal zu erzeugen, wenn der Anfang oder das Ende einer Teilungsperiode der Maßverkörperung 6 erfasst wird. Sobald die Steuerung 8, beispielsweise ein entsprechend programmierter Mikro- oder Signalprozessor des Druckers 3, von dem Sensor 4 das Signal erhält, wird der Drucker von der Steuerung 8 angesteuert und von dem Drucker Beschichtungsmaterial auf die Außenfläche des Endlosbandes 2 projiziert. Der Sensor 4 und die Maßverkörperung 6 bilden hierbei einen Inkrementalgeber zur Steuerung des Druckvorganges. Erst wenn der Inkrementalgeber ein entsprechendes Signal erzeugt, wird der Druckvorgang ausgelöst. Da sich der geometrische oder zeitliche Abstand zwischen zwei Teilstrichen durch Banddehnungen oder Geschwindigkeitsänderungen verändert, können bei dem Druckvorgang Banddehnungen oder Geschwindigkeitsänderungen des umlaufenden Endlosbandes 2 unmittelbar berücksichtigt werden.

Um eine sichere Detektion auch im Bereich einer Stoßstelle der Maßverkörperung 6, die als im Wesentlichen geschlossener Ring um die das Endlosband 2 umlaufen kann, zu gewährleisten, kann in der Maßverkörperung 6 und in dem Endlosband 2 im Bereich des Stoßes eine Referenzmarkierung, beispielsweise in Form eines Lochs 14, angeordnet sein, welche mit einem Sensor 15 erfasst werden kann. Wenn der Sensor 15 die Referenzmarkierung bzw. das Loch 14 erkennt, so kann ein entsprechendes Signal an die Steuerung 8 übermittelt werden. Nach Erkennung der Referenzmarkierung bzw. des Lochs 14 kann beispielsweise der unmittelbar darauf folgende Teilstrich für die Auslösung des Druckvorganges unberücksichtigt bleiben, um ein korrektes Bedrucken des Endlosbandes 2 zu gewährleisten.

Ein weiterer photosensitiver Sensor 5, beispielsweise eine Kamera, dient dazu, die Position einer weiteren optisch erfassbaren Maßverkörperung 7, welche als durchgehende Linie mit scharfen Kanten ausgebildet sein kann, zu erfassen.

Die Maßverkörperungen 6, 7 können kraftschlüssig auf eine Oberfläche des Endlosbandes 2 aufgebracht werden. So können die Maßverkörperungen 6, 7 beispielsweise durch Auftragen von Farbe auf das Endlosband 2 realisiert sein oder durch Verkleben eines Trägermaterials der Maßverkörperungen 6, 7 mit dem Endlosband 2 verbunden werden. Alternativ hierzu können die Maßverkörperungen 6, 7 aber auch durch andere Verfahren, wie Materialabtragen, insbesondere mittels eines Lasers oder durch Ätzen, Prägen oder Umformen von Abschnitten des Endlosbandes 2 oder Magnetisieren des Endlosbandes 2 erzeugt werden. Weiters sind die Maßverkörperungen 6, 7 jeweils an einem Rand des Endlosbandes 2, parallel zu einer Seitenkante und außerhalb des bedruckten Bereichs angeordnet. Die Maßverkörperungen 6, 7 können abweichend von der dargestellten Ausführungsform, in welcher die Maßverkörperungen 6, 7 auf einer Bandaußenfläche des Endlosbandes 2 angeordnet sind, jedoch auch auf einer Seitenfläche bzw. Seitenkante des Endlosbandes 2 oder auf einer Bandinnenseite angeordnet sein.

An dieser Stelle sei darauf hingewiesen, dass die unterschiedlichen Funktionen der Maßverkörperungen 6, 7 auch in einer einzigen Maßverkörperung zusammengefasst und realisiert sein können.

Die Position der Maßverkörperung 7 in Bezug auf eine Querrichtung des Endlosbandes 2 wird mittels des Sensors 5 erfasst, wobei die Position des Druckers entsprechend einer Abweichung der Maßverkörperung 7 von einer Sollposition in Richtung der Querrichtung des Endlosbandes 2 verändert wird. Der Drucker 3 kann hierbei mittels eines Aktors 9 in Querrichtung des Endlosbandes 1 verschoben werden. Der Aktor 9, beispielsweise ein Spindelantrieb, kann mit einer mit dem zumindest einen Sensor 5 verbundenen Steuerung 10 verbunden sein, die dazu eingerichtet ist, den Aktor 9 entsprechend einer Abweichung der Position der Maßverkörperung 7 von einer Sollposition zu verstellen.

Die Bewegungsrichtung des Druckers ist in Fig. 1 mit einem Doppelpfeil angedeutet. Weiters können der Sensor 5 und der Drucker 3 auf einem Gestell 11 gemeinsam verschoben werden. Hierzu können der Sensor 5 und der Drucker 3 beispielsweise auf einer gemeinsamen Platte oder einem Tisch, der verschiebbar an das Endlosband 2 in Querrichtung übergreifenden Profilen gelagert sein. Unter dem Drucker 3 bzw. dem Gestell 11 ist das Endlosband 2 zwischen zwei Rollen 12 und 13 umlaufen, von welchen eine als Antriebsrolle und die andere als Umlenkrolle dienen kann. Die Bewegungsrichtung des Endlosbandes 2 ist mit einem Pfeil angedeutet.

Die Sollposition der Maßverkörperung 7 kann in Bezug auf eine Sensorfläche des optischen Sensors 5 festgelegt werden. So kann beispielsweise definiert werden, dass die Maßverkörperung 7 immer in einem definierten mittleren Bereich der Sensorfläche liegen muss. Bei einer (seitlichen) Abweichung der tatsächlichen Lage der Maßverkörperung 7von der Sollposition, kann Position des Sensors 5 solange durch Verschieben in Richtung des Doppelpfeils geändert werden, bis die tatsächliche Lage der zumindest einen Maßverkörperung 7 auf der Sensorfläche mit der Sollposition übereinstimmt, wodurch auch der Drucker entsprechend mitbewegt und in die korrekte Druckposition gebracht wird.

Die Ausführungsbeispiele zeigen mögliche Ausführungsvarianten der erfindungsgemäßen Vorrichtung bzw. des erfindungsgemäßen Verfahrens, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, sowie alle weiteren nicht beschriebenen und dargestellten Ausführungsformen, die unter den Wortlaut der unabhängigen Ansprüche fallen vom Schutzumfang mitumfasst.

Der Ordnung halber sei abschließend darauf hingewiesen, dass zum besseren Verständnis des Aufbaus der erfindungsgemäßen Vorrichtung diese bzw. deren Bestandteile teilweise unmaßstäblich und/oder vergrößert und/oder verkleinert dargestellt wurden.

## Patentansprüche

1. Verfahren zum Aufbringen einer maskenförmigen Beschichtung auf ein Endlosband (2), wobei die Beschichtung mittels eines Druckers (3) in Tropfenform auf eine Außenfläche des Endlosbandes (2) aufgetragen wird, wobei das Endlosband (2) während eines Druckvorganges unter dem in Bewegungsrichtung des Endlosbandes (2) stationären Drucker (3) durchläuft, wobei das Endlosband (2) zwischen zwei Rollen umläuft, **gekennzeichnet, durch** folgende Schritte:
a) Aufbringen oder Übertragen zumindest einer periodische Unterteilungen aufweisenden Maßverkörperung (6, 7) auf das Endlosband (2), insbesondere auf eine Oberfläche des Endlosbandes (2);
b) Erfassen der Position der Maßverkörperung (6, 7) und einer periodischen Teilung der Maßverkörperung (6, 7) mittels zumindest eines Sensors (4, 5);
c) Erzeugen eines Signals zum Drucken und Übermittlung an den Drucker (3), wenn die von dem zumindest einen Sensor (4, 5) erfasste Position der Maßverkörperung (6, 7) auf der Oberfläche des Endlosbandes (2) einer Sollposition entspricht und wenn der zumindest eine Sensor (4, 5) ein Ende oder einen Anfang einer Teilungsperiode der Maßverkörperung (6, 7) detektiert;
d) Ausstoßen von Tropfen eines Beschichtungsmaterials auf die Außenfläche des Endlosbandes (2) mittels des Druckers (3) nach Erhalt des Signals, wobei die Sollposition der zumindest einen Maßverkörperung (6, 7) auf einer Sensorfläche des zumindest einen optischen Sensor (5) festgelegt wird, wobei bei einer Abweichung der Sollposition und der tatsächlichen Lage der Maßverkörperung, die Position des Sensors (5) solange geändert wird, bis die tatsächliche Lage der zumindest einen Maßverkörperung (6, 7) auf der Sensorfläche mit der Sollposition übereinstimmt,
**dadurch gekennzeichnet, dass** die Position der zumindest einen Maßverkörperung in Bezug auf eine Querrichtung des Endlosbandes mittels zumindest eines optischen Sensors (50) erfasst wird, wobei die Position des Druckers entsprechend einer Abweichung der Maßverkörperung von einer Sollposition in Richtung der Querrichtung des Endlosbandes verändert wird.

2. Verfahren nach Anspruch 1, **dadurch gekennzeichnet, dass** in Schritt a) die zumindest eine Maßverkörperung (6, 7) parallel zu einer Seitenkante und/oder auf eine Seitenfläche, die eine Bandinnenfläche mit einer Bandaußenfläche des Endlosbandes (2) verbindet, und in Umfangsrichtung umlaufend auf die Oberfläche des Endlosbandes (2) aufgebracht wird.

3. Verfahren nach Anspruch 2, **dadurch gekennzeichnet, dass** in Schritt a) zumindest eine Referenzmarkierung zur Festlegung zumindest eines Referenzpunktes für die Erfassung von Teilstrichen (16) der zumindest einen Maßverkörperung (6, 7) auf und/oder in dem Endlosband (2) angebracht wird.

4. Verfahren nach Anspruch 2 oder 3, **dadurch gekennzeichnet, dass** in Schritt a) zumindest zwei Maßverkörperungen (6, 7) auf das Endlosband (2) aufgebracht werden, wobei eine erste der Maßverkörperungen (6) Teilstriche (16), die eine periodische Teilung definieren, aufweist, während eine zweite der Maßverkörperungen (6, 7) als kontinuierliche Maßverkörperung (7), insbesondere in Form einer Linie, ausgebildet ist, wobei in Schritt b) die Teilstriche (16) der ersten Maßverkörperung (6) mit einem ersten Sensor (4) und die Position der zweiten Maßverkörperung (7) mit einem zweiten Sensor (5) erfasst werden.

5. Verfahren nach einem der Ansprüche 1 bis 4, **dadurch gekennzeichnet, dass** die zumindest eine Maßverkörperung (6) in Schritt a) kraftschlüssig auf das Endlosband (2) aufgebracht oder durch Materialabtragen, insbesondere mittels eines Lasers oder durch Ätzen, Prägen oder Umformen von Abschnitten des Endlosbandes (2) oder durch Magnetisieren des Endlosbandes (2) erzeugt wird.

6. Vorrichtung (1) zum Auftragen einer maskenförmigen Beschichtung auf ein Endlosband (2), wobei die Vorrichtung (1) zumindest einen Drucker (3) zum Ausstoßen zumindest eines Beschichtungsmaterials auf eine Außenfläche des Endlosbandes (2) in Tropfenform umfasst, , wobei die Vorrichtung (1) zumindest einen Sensor (4, 5) zur Erfassung eines Anfangs oder Endes einer Teilungsperiode zumindest einer auf dem Endlosband (1) aufgebrachten, periodische Unterteilungen aufweisenden Maßverkörperung (6, 7) und der Position der zumindest einen Maßverkörperung (6, 7) aufweist, wobei der zumindest eine Sensor (4, 5) dazu eingerichtet ist, zumindest ein Signal zu erzeugen, wenn der Anfang oder das Ende einer Teilungsperiode und/oder eine Abweichung von der Position der zumindest einen Maßverkörperung (6, 7) von einer Sollposition erfasst wird, wobei der zumindest eine Sensor (4, 5) mit zumindest einer Steuerung (8) des zumindest einen Druckers (3) verbunden ist, die dazu eingerichtet ist, in Abhängigkeit von dem von dem zumindest einen Sensor (4, 5) erzeugten, zumindest einen Signal den zumindest einen Drucker (3) zum Ausstoßen von Beschichtungsmaterial anzusteuern, wobei der zumindest eine Sensor (4, 5) und der Drucker (3) mechanisch miteinander gekoppelt sind, insbesondere auf einem Gestell (11) gemeinsam verschiebbar angeordnet sind, **dadurch gekennzeichnet, dass** die Steuerung (8) eingerichtet ist, die Position der zumindest einen Maßverkörperung (6, 7) in Bezug auf eine Querrichtung des Endlosbandes (2) mittels zumindest eines optischen Sensors (5) zu erfassen und die Position des Druckers entsprechend einer Abweichung der Maßverkörperung (6, 7) von einer Sollposition in Richtung der Querrichtung des Endlosbandes (2) zu verändern.

7. Vorrichtung nach Anspruch 6, **dadurch gekennzeichnet, dass** der zumindest eine Drucker (3) mittels zumindest eines Aktors (9) in Querrichtung des Endlosbandes (1) verschiebbar ist.

8. Vorrichtung nach Anspruch 7, **dadurch gekennzeichnet, dass** der Aktor (9) mit einer mit dem zumindest einen Sensor (4, 5) verbundenen Steuerung (10) verbunden ist, die dazu eingerichtet ist, den Aktor (9) entsprechend einer Abweichung der Position der Maßverkörperung (6, 7) von einer Sollposition zu verstellen.

## Claims

1. A method for applying a mask-shaped coating to an endless belt (2), wherein the coating is applied to an outer surface of the endless belt (2) in the form of drops by means of a printer (3), wherein, during a printing operation, the endless belt (2) passes under the printer (3) that is stationary in the direction of movement of the endless belt (2), wherein the endless belt (2) circulates between two rollers, **characterized by** the following steps:
a) applying or transferring at least one measuring standard (6, 7) having periodic graduations to the endless belt (2), in particular to a surface quality of the endless belt (2);
b) detecting the position of the measuring standard (6, 7) and a periodic graduation of the measuring standard (6, 7) by means of at least one sensor (4, 5);
c) creating a signal for printing and transmission to the printer (3) when the position of the measuring standard (6, 7) on the surface of the endless belt (2), detected by the at least one sensor (4, 5), corresponds with a target position and when the at least one sensor (4, 5) detects an end or a start of a graduation interval of the measuring standard (6, 7);
d) ejecting drops of a coating material onto the outer surface of the endless belt (2) by means of the printer (3) after receiving the signal,
wherein the target position of the at least one measuring standard (6, 7) is determined on a sensor surface of the at least one optical sensor (5), wherein in case of a deviation between the target position and the actual position of the measuring standard, the position of the sensor (5) is changed until the actual position of the at least one measuring standard (6, 7) corresponds with the target position on the sensor surface, **characterized in that** the position of the at least one measuring standard with respect to a transverse direction of the endless belt is detected by means of at least one optical sensor (50), wherein the position of the printer is changed according to a deviation of the measuring standard from a target position in the direction of the transverse direction of the endless belt.

2. The method according to claim 1, **characterized in that** in step a), the at least one measuring standard (6, 7) connects the one belt inner surface to a belt outer surface of the endless belt (2) in parallel with a lateral edge and/or to a lateral edge and is applied to the surface of the endless belt (2) circumferentially in the circumferential direction.

3. The method according to claim 2, **characterized in that** in step a), at least one reference marking for determining at least one reference point for detecting graduation marks (16) of the at least one measuring standard (6, 7) is installed to and/or in the endless belt (2).

4. The method according to claim 2 or 3, **characterized in that** in step a), at least two measuring standards (6, 7) are applied to the endless belt (2), wherein a first one of the measuring standards (6) has graduation marks (16) defining a periodic graduation, while a second one of the measuring standards (6, 7) is formed as a continuous measuring standard (7), in particular in the form of a line, wherein in step b), the graduation marks (16) of the first measuring standard (6) are detected by a first sensor (4), and the position of the second measuring standard (7) is detected by a second sensor (5).

5. The method according to one of claims 1 to 4, **characterized in that** in step a), the at least one measuring standard (6) is applied to the endless belt (2) in a force-fitting manner or is created by material removal, in particular by means of a laser or by etching, embossing, or deforming of sections of the endless belt (2) or by magnetizing the endless belt (2).

6. A device (1) for applying a mask-shaped coating to an endless belt (2), wherein the device (1) comprises at least one printer (3) for ejecting at least one coating material onto an outer surface of the endless belt (2) in the form of drops, wherein the device (1) has at least one sensor (4, 5) for detecting a beginning or end of a graduation interval of at least one measuring standard (6, 7) applied to an endless belt (1) and having periodic graduations, and the position of the at least one measuring standard (6, 7), wherein the at least one sensor (4, 5) is configured to generate at least one signal when the beginning or the end of a graduation interval and/or a deviation from the position of the at least one measuring standard (6, 7) from a target position is detected, wherein the at least one sensor (4, 5) is connected to at least one controller (8) of the at least one printer (3), which controller (8) is configured to control the at least one printer (3) for ejecting coating material, depending on the at least one signal generated by the at least one sensor (4, 5), wherein the at least one sensor (4, 5) and the printer (3) are mechanically coupled to one another, in particular are arranged on a frame (11) so as to be jointly displaceable, **characterized in that** the controller (8) is configured to detect the position of the at least one measuring standard (6, 7) with respect to a transverse direction of the endless belt (2) by means of an optical sensor (5) and to change the position of the printer according to a deviation of the measuring standard (6, 7) from a target position in the direction of the transverse direction of the endless belt (2).

7. The device according to claim 6, **characterized in that** the at least one printer (3) is displaceable in the transverse direction of the endless belt (1) by means of an actuator (9).

8. The device according to claim 7, **characterized in that** the actuator (9) is connected to a controller (10) connected to the at least one sensor (4, 5), which controller (10) is configured to adjust the actuator (9) according to a deviation of the position of the measuring standard (6, 7) from a target position.

## Revendications

1. Procédé d'application d'un revêtement en forme de masque sur une bande sans fin (2), dans lequel le revêtement est appliqué au moyen d'une imprimante (3) sous la forme de gouttes sur une surface externe de la bande sans fin (2), dans lequel la bande sans fin (2) se déplace, au cours d'un processus d'impression, sous l'imprimante stationnaire (3), en direction de la bande sans fin (2), dans lequel la bande sans fin (2) est disposé entre deux rouleaux, **caractérisé par** les étapes suivantes :
a) application ou transfert d'au moins une matérialisation de mesures (6, 7), comprenant des divisions périodiques, sur la bande sans fin (2), plus particulièrement sur une surface supérieure de la bande sans fin (2) ;
b) détection de la position de la matérialisation des dimensions (6, 7) et d'une division périodique de la matérialisation des dimensions (6, 7) au moyen d'au moins un capteur (4, 5);
c) génération d'un signal pour l'impression et transmission à l'imprimante (3) lorsque la position détectée par l'au moins un capteur (4, 5), de la matérialisation des dimensions (6, 7) sur la surface supérieure de la bande sans fin (2) correspond à une position de consigne et lorsque l'au moins un capteur (4, 5) détecte une fin ou un début d'une période de division de la matérialisation des dimensions (6, 7) ;
d) expulsion de gouttes d'un matériau de revêtement sur la surface externe de la bande sans fin (2) au moyen de l'imprimante (3) après la réception du signal, dans lequel la position de consigne de l'au moins une matérialisation des dimensions (6, 7) est définie sur une surface de capteur de l'au moins un capteur optique (5), dans lequel, lors d'un écart de la position de consigne et de la position réelle de la matérialisation des dimensions, la position du capteur (5) est modifiée jusqu'à ce que la position réelle de l'au moins une matérialisation des dimensions (6, 7) sur la surface du capteur coïncide avec la position de consigne,
**caractérisé en ce que** la position de l'au moins une matérialisation des dimensions par rapport à une direction transversale de la bande sans fin est déterminée au moyen d'au moins un capteur optique (50), dans lequel la position de l'imprimante est modifiée en fonction d'un écart de la matérialisation des dimensions par rapport à une position de consigne dans la direction transversale de la bande sans fin.

2. Procédé selon la revendication 1, **caractérisé en ce que**, à l'étape a), l'au moins une matérialisation des dimensions (6, 7) est appliquée parallèlement à une arête latérale et/ou sur une surface latérale qui relie une surface interne avec une surface externe de la bande sans fin (2), et est appliquée dans la direction circonférentielle de manière circulaire sur la surface supérieure de la bande sans fin (2).

3. Procédé selon la revendication 2, **caractérisé en ce que**, à l'étape a), au moins un marquage de référence est appliqué pour la définition d'au moins un point de référence pour la détection de traits de division (16) de l'au moins une matérialisation des dimensions (6, 7) sur et/ou dans la bande sans fin (2).

4. Procédé selon la revendication 2 ou 3, **caractérisé en ce que**, à l'étape a), au moins deux matérialisations de dimensions (6, 7) sont appliquées sur la bande sans fin (2), dans lequel une première des matérialisations des dimensions (6) comprend des traits de division (16) qui définissent une division périodique, tandis qu'une deuxième des matérialisations des dimensions (6, 7) est réalisée sous la forme d'une matérialisation des dimensions continue (7), plus particulièrement sous la forme d'une ligne, dans lequel, à l'étape b), les traits de division (16) de la première matérialisation des dimensions (6) sont détectées avec un premier capteur (4) et la position des deuxièmes matérialisations de dimensions (7) est détectée avec un deuxième capteur (5).

5. Procédé selon l'une des revendications 1 à 4, **caractérisé en ce que** l'au moins une matérialisation des dimensions (6) est appliquée, à l'étape a), par force, sur la bande sans fin (2) ou est réalisée par enlèvement de matière, plus particulièrement au moyen d'un laser ou par gravure, estampage ou déformation de portions de la bande sans fin (2) ou par magnétisation de la bande sans fin (2).

6. Dispositif (1) pour l'application d'un revêtement en forme de masque sur une bande sans fin (2), dans lequel le dispositif (1) comprend au moins une imprimante (3) pour l'expulsion d'au moins un matériau de revêtement sur une surface externe de la bande sans fin (2) sous la forme de gouttes, dans lequel le dispositif (1) comprend au moins un capteur (4, 5) pour la détection d'un début ou de la fin d'une période de division d'au moins une matérialisation des dimensions (6, 7), appliquée sur la bande sans fin (1), comprenant des divisions périodiques et de la position de l'au moins une matérialisation des dimensions (6, 7), dans lequel l'au moins un capteur (4, 5) est conçu pour générer au moins un signal lorsque le début ou la fin d'une période de division et/ou un écart de la position de l'au moins une matérialisation des dimensions (6, 7) par rapport à une position de consigne est détecté, dans lequel l'au moins un capteur (4, 5) est relié avec au moins une commande (8) de l'au moins une imprimante (3), qui est conçue pour contrôler, en fonction de l'au moins un signal généré par l'au moins un capteur (4, 5), l'au moins une imprimante (3) pour l'expulsion du matériau de revêtement, dans lequel l'au moins un capteur (4, 5) et l'imprimante (3) sont couplés entre eux de manière mécanique, plus particulièrement sont disposés ensemble de manière coulissante sur un châssis (11), **caractérisé en ce que** la commande (8) est conçue pour détecter la position de l'au moins une matérialisation des dimensions (6, 7) par rapport à une direction transversale de la bande sans fin (2) au moyen d'au moins un capteur optique (5) et pour modifier la position de l'imprimante en fonction d'un écart de la matérialisation des dimensions (6, 7) par rapport à une position de consigne dans la direction transversale de la bande sans fin (2).

7. Dispositif selon la revendication 6, **caractérisé en ce que** l'au moins une imprimante (3) peut coulisser à l'aide d'au moins un actionneur (9) dans la direction transversale de la bande sans fin (1).

8. Dispositif selon la revendication 7, **caractérisé en ce que** l'actionneur (9) est relié avec une commande (10), reliée avec l'au moins un capteur (4, 5), qui est conçue pour déplacer l'actionneur (9) en fonction d'un écart de la position de la matérialisation des dimensions (6, 7) par rapport à une position de consigne.
